# EUROPEAN PATENT SPECIFICATION

(11) **EP 1 418 022 B1**
(45) Date of publication and mention of the grant of the patent: **06.01.2010**
(21) Application number: 03025624.2
(22) Date of filing: 06.11.2003
(51) Int. Cl.: B24B 37/04, B24B 47/22

(54) **Vertically adjustable chemical mechanical polishing head having a pivot mechanism and method for use thereof**
Höhenverstellbare chemisch-mechanische Polierträgervorrichtung mit Schwenkmechanismus und Verfahren zum Anwenden derselben
Tête de polissage équipée d'un mécanisme pivotant mécano-chimique réglable verticalement et procédé pour sa mise en oeuvre

(30) Priority: 07.11.2002 US 425125 P
(43) Date of publication of application: 12.05.2004
(73) Proprietor: Ebara Technologies Incorporated, Sacramento, CA 95838 (US)
(72) Inventor: Sakurai, Kunihiko, San Jose, CA 95134 (US); Moloney, Gerard, Milpitas, CA 95035 (US); Wang, Huey-Ming, Fremont, CA 94555 (US); Liu, Jun, Cupertino, CA 95014 (US); Lao, Peter, San Jose, CA 95133 (US)
(74) Representative: Wagner, Karl H.

(56) References cited:
- WO-A-01/87541

## Description

### Technical Field

This invention relates generally to chemical mechanical polishing (CMP) as for example disclosed in JP-A-11277417, and more particularly, but not exclusively, provides a chemical mechanical polishing apparatus having a pivot mechanism and method for use thereof according to the preamble of claim 1 and 14.

### Background

CMP is a combination of chemical reaction and mechanical buffing. A conventional CMP system includes a polishing head with a retaining ring that holds and rotates a substrate (also referred to interchangeably as a wafer) against a pad surface rotating in the opposite direction or same direction. The pad can be made of cast and sliced polyurethane (or other polymers) with a filler or a urethane coated felt.

During rotation of the substrate against the pad, a slurry of silica (and/or other abrasives) suspended in a mild etchant, such as potassium or ammonium hydroxide, is dispensed onto the pad. The combination of chemical reaction from the slurry and mechanical buffing from the pad removes vertical inconsistencies on the surface of the substrate, thereby forming an extremely flat surface.

However, conventional CMP systems have several shortcomings including process instability that can lead to inconsistent polish profiles of substrates; table to table and tool to tool variation that can lead to inconsistent polish profiles of substrates processed on different CMP systems; and process optimization difficulty that makes it difficult to balance pressure within air-pressurized chambers due to a plurality of pressure controllers.

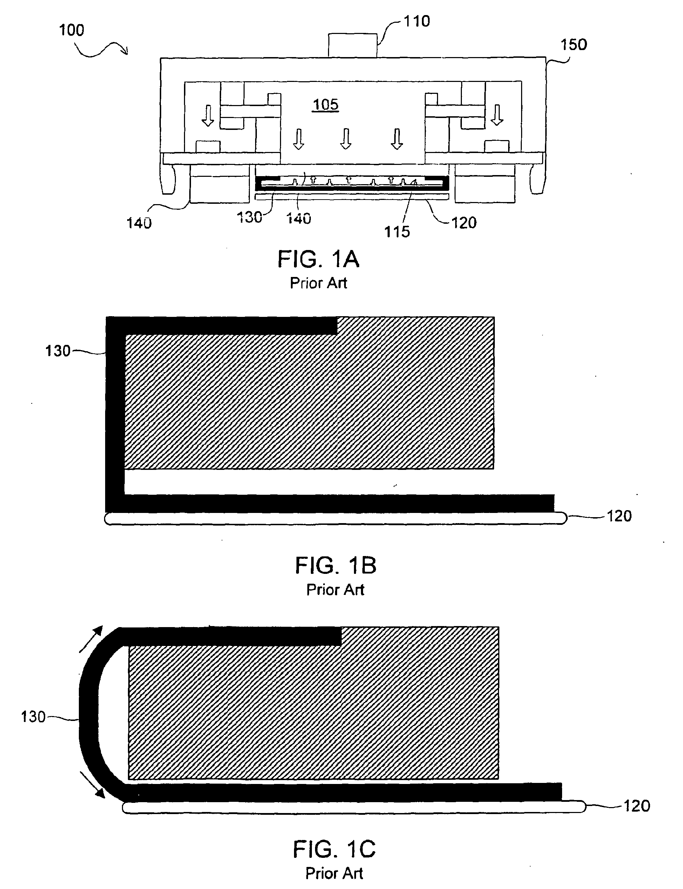

FIG. 1A is a block diagram illustrating a cross section of a prior art polishing head 100 that exhibits the above-mentioned deficiencies. A retaining ring 140 is cylindrical in shape and holds a substrate 120 (also referred to as a wafer) in place during CMP. An air pressure/force balancing method, as indicated by the arrows in FIG. 1A, is used to maintain a downward pressing force against a shaft and the substrate 120 during CMP.
In addition, to prevent a plate 140 from ballooning out of the polishing head 100, supplied pressure exerts an upward force.

However, these above-mentioned forces are subject to process instability, which can lead to inconsistent polish profiles of substrates. Specifically, the above-mentioned forces are each powered by air pressure administered by air pressure controllers. The controllers each have their own tolerances that can lead to errors in the amount of air pressure applied. For example, if the pressure in region 105 is greater than the pressure in region 115, the plate 140 is placed in a position that is lower than expected position. A rubber insert 130 is formed as shown FIG. 1B (and is different from FIG. 1C when the plate 140 is placed in the expected position). In the condition shown in FIG. 1B, the plate 140 compresses the edge of rubber insert 130 due to the pressure difference between region 105 and 115. This compressing force gives a pressure on the edge of the substrate 120 that is different from a pressure on the other region provided by air pressure in region 115. As a result, excess pressure is applied on an edge of the substrate 120 and it increases a polishing rate of the substrate 120.

Further, there can be additional variation between conventional CMP systems that lead to inconsistent profiles between substrates. In addition, it can be hard to optimize the process in conventional CMP systems so that the forces required are adequately and consistently balanced.

Another shortcoming of conventional CMP systems is that CMP heads always get lowered to the same position even though the pads wear down over time. This can lead to the insufficient polishing of substrates.

JP 11-277,417 A discloses a chemical mechanical polishing head comprising a carrier capable of adjusting its vertical position relative to a substrate on a polishing pad and capable of fixing the height during CMP; a rubber sheet coupled to the carrier so as to form a chamber capable of receiving air, the received air supplying a substrate polishing down force within the chamber.

Therefore, a system and method are needed that overcome the above mentioned deficiencies.

### SUMMARY

The invention provides an adjustable chemical mechanical polishing apparatus for polishing a substrate placed on a polishing pad, as set forth in claim 1. Moreover, the present invention provides a method of chemical mechanical polishing of a substrate against a polishing pad, as set forth in claim 14. Preferred embodiments of the present invention may be gathered from the dependent claims.

### BRIEF DESCRIPTION OF THE DRAWINGS

Embodiments of the present invention are described with reference to the following figures, wherein like reference numerals refer to like parts throughout the various views unless otherwise specified.
FIG. 1A is a block diagram illustrating a cross section of a prior art polishing head;
FIG. 1B and FIG. 1C are diagrams illustrating a portion of the prior art polishing head an uncompressed and a compressed state, respectively;
FIG. 2 is a block diagram illustrating a cross section of polishing head according to an embodiment of the invention;
FIG. 3 is a top view illustrating a polishing head according to an embodiment of the invention;
FIG. 4 is a cross section illustrating the polishing head 300 of FIG. 3;
FIG. 5 is a second cross section illustrating the polishing head of FIG. 3;
FIG. 6 is a third cross section illustrating the polishing head of FIG. 3;
FIG. 7 is a fourth cross section illustrating the polishing head of FIG. 3;
FIG. 8 is a flowchart illustrating a method of chemical mechanical polishing;
FIG. 9A - 9D are block diagrams illustrating a polishing system incorporating a height-adjustable head;
FIG. 10 is a block diagram illustrating the polishing system of FIG. 9A in an uncompressed state;
FIG. 11 is a block diagram illustrating an example computer capable of controlling the polishing system of FIG. 9A;
FIG. 12 is a block diagram illustrating a positioning system;
FIG. 13 is a flowchart illustrating a method of positioning a CMP head; and
FIG. 14 is a flowchart illustrating a second method of positioning a CMP head.

### DETAILED DESCRIPTION OF THE ILLUSTRATED EMBODIMENTS

The following description is provided to enable any person of ordinary skill in the art to make and use the invention, and is provided in the context of a particular application and its requirements.

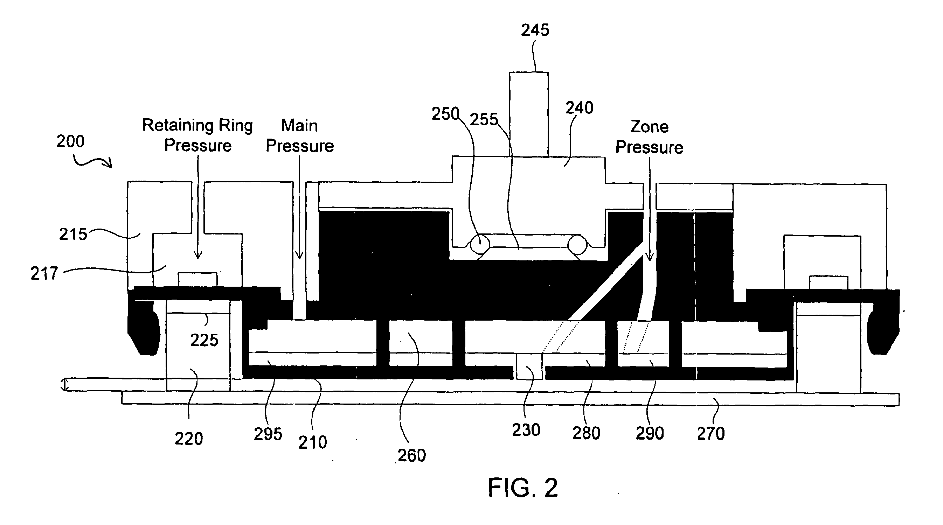

FIG. 2 is a block diagram illustrating a cross section of polishing head 200 according to an embodiment of the invention. The polishing head 200 includes a upper housing 215, retaining ring 220; retaining ring adapter 225; drive flange 240; shaft 245; ball bearings 250; dome 255; sub carrier 260; rubber insert 210; and reference point 230.

The retaining ring 220 is cylindrical in shape and retains a substrate during CMP. The retaining ring 220 has an inner diameter of at least about 200 mm to about 203 mm for a 200 mm substrate or at least 300 mm to about 303 mm for a 300 mm substrate. The retaining ring 220 has an outer diameter of about 230 mm to about 275 mm for a 200 mm substrate or about 330 mm to 375 mm for a 300 mm substrate. The retaining ring 220 is coupled to the upper housing 215 via a diaphragm (not shown) and the retaining ring adapter 225, which has inner and outer diameters substantially similar to the inner and outer diameters of the retaining ring 220.

The drive flange 240 has a bottom surface that is pivotally coupled to the dome 255 via the ball bearings 250. The dome 255 is coupled to the base flange 265. The base flange 265 is also coupled to the sub carrier 260 and rubber insert 210. The reference point 230 is attached on the sub carrier 260 and can have a soft pad on the bottom thereof.

The shaft 245 extends upwards from the drive flange 240 and is cylindrical in shape. The ball bearings 250 comprises a plurality of ceramic balls, each having a diameter of about 5/16 of an inch. In an embodiment of the invention, the ball bearings 250 includes fifteen ceramic balls. The dome 255 is dome shaped with a flat top.

The sub carrier 260 is cylindrical in shape and has a diameter about equal to the diameter of a substrate (e.g., about 200 mm or about 300 mm). The reference point 230 is also cylindrical in shape and can have a diameter of just a few millimeters. The rubber insert 210 forms several air pressure zones or chambers, such as zones 280, 290, and 295, by walling off volume between the rubber insert 210 and the sub carrier 260.

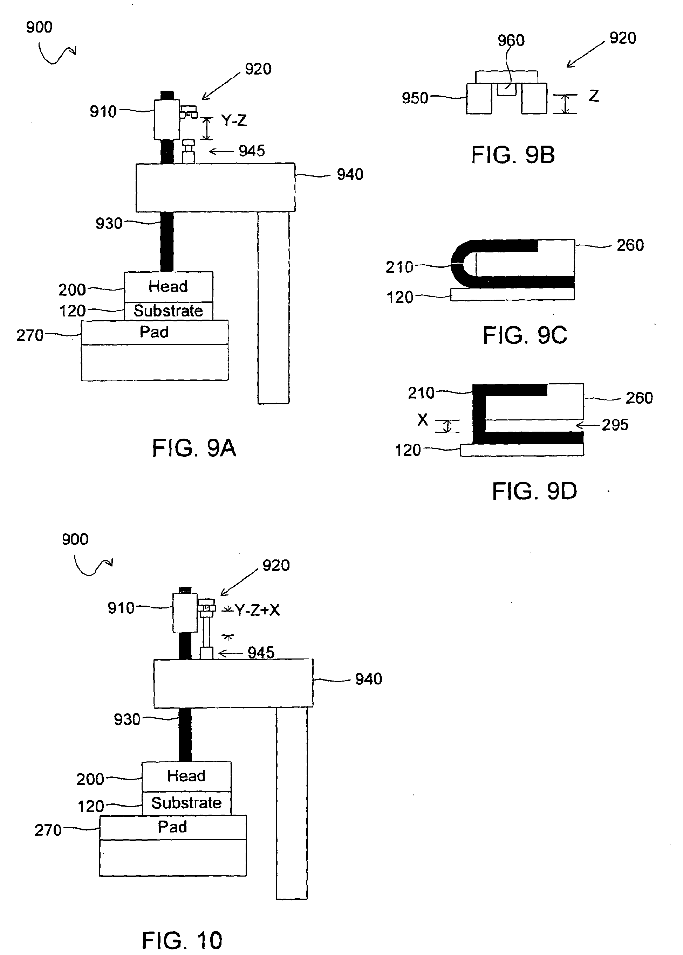

During CMP, the retaining ring 220 retains a substrate for processing. Pressure is then applied to the drive flange 240 forcing the polishing head 200 downwards until a bracket 950 contacts a stopper assembly 945 (FIG. 9). Controllable retaining ring air pressure is then supplied to a zone 217 to force the retaining ring 220 downwards. Controllable main air pressure is also supplied to zone 295. Additional controllable zone air pressure can also be supplied to zones 280 and 290. The main pressure and zone air pressure act to press the rubber insert 210 against a substrate thereby forcing the substrate to interact with the polishing pad 270 during CMP. Further, the main pressure and zone pressure place upward pressure on the sub carrier 260.

A pivot mechanism (comprising the ball bearings 250) enables the pivoting of the polishing head 200 based on the main pressure and zone pressure. If the shaft 245 is not assembled vertical to the polishing pad 270, the pivot mechanism enables the polishing head 200 to align parallel to the polishing pad 270. The polishing head 200 can hang a short distance from the drive flange 240 via 3 springs and 3 pins. Once the polishing head 200 is placed on the polishing pad 270 and pressure is applied on the retaining ring 220 and the back side of the wafer, the upper housing 215 receives upward force through the base flange (not shown), which is enough to push up the whole polishing head assembly 200 until the dome 255 on the top of the polishing head 200 contacts the ball bearings 250 coupled to the drive flange 240 so that the polishing head 200 can pivot and align in parallel with the polishing pad 270. Accordingly, the sub carrier 260 and the insert 210 can keep the same vertical position at each polishing.

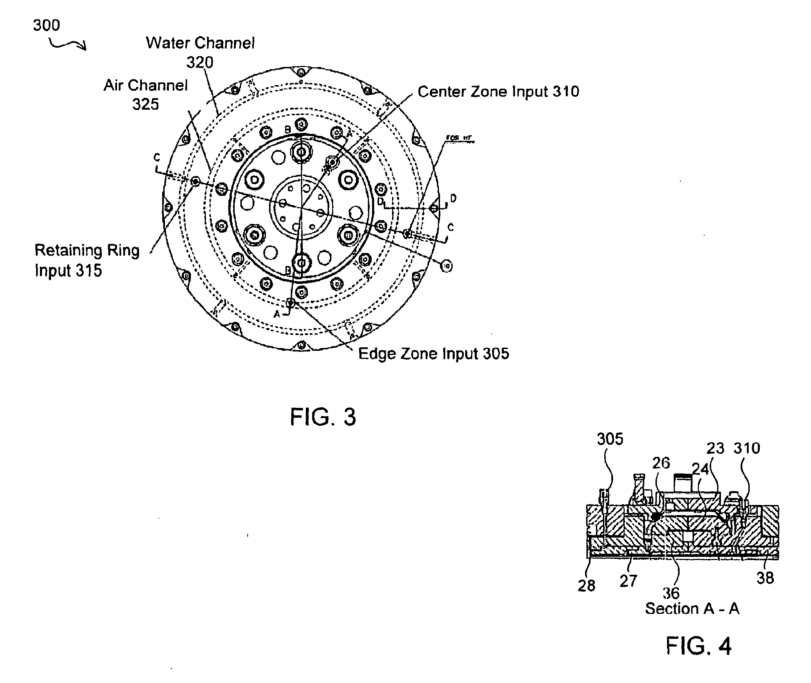

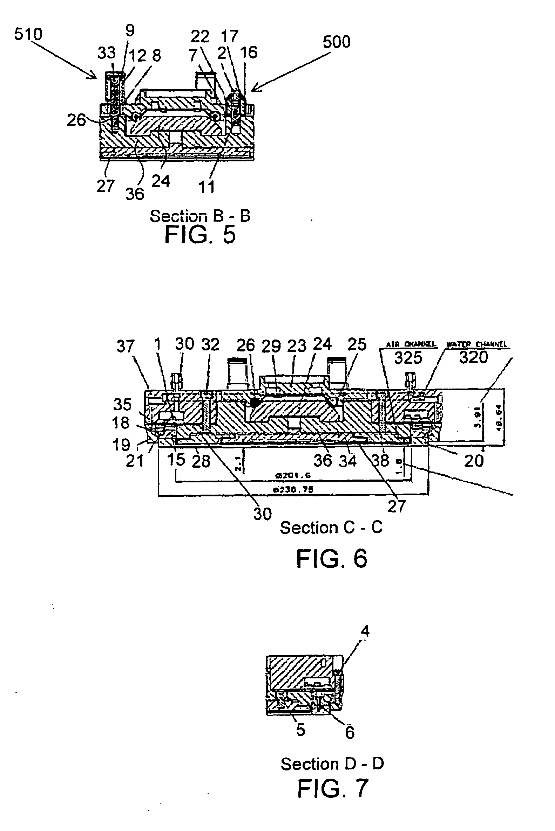

FIG. 3 is a top view of a polishing head 300 according to an embodiment of the invention. The polishing head 300 is cylindrical in shape with an outer diameter of about 250 mm for 200 mm substrates or about 350 mm for 300 mm substrates. Different cross-sections of the polishing head 300 will be discussed in further detail in conjunction with FIG. 4, FIG. 5, FIG. 6., and FIG. 7.

The polishing head 300 comprises a plurality of air pressure inputs, including a center zone input 310; an edge zone input 305; and a retaining ring input 315. The polishing head 300 also comprises an air channel 325 and a water channel 320. The air pressure inputs 305, 310 and 315 each independently supply controllable air pressure to different zones within the polishing head 300. The retaining ring input 315 supplies air pressure to a retaining ring zone so as to apply downward pressure on a retaining ring 20 (FIG. 6) during CMP. The center zone input 310 supplies air pressure to a center zone within the polishing head 300 that is formed by an inner rubber insert 27 (FIG. 6) and a sub carrier 38 (FIG. 6). The edge zone input 305 supplies air pressure to the air channel 325, which is in communication with an edge zone that is formed by an outer rubber insert 28 (FIG. 6) and the sub carrier 38.

FIG. 4 is a cross section illustrating the polishing head 300 of FIG. 3. The cross section illustrates a flange drive 23; a dome 24; ball bearings 26; an inner rubber insert 27; an outer rubber insert 28; a base flange 36; and a sub carrier 38. The dome 24 is pivotly coupled to the flange drive 23 via the ball bearings 26. The flange drive 23 is also cylindrically shaped and pressure applied to the top of the flange drive 23 forces the polishing head 300 in a downward direction. The base flange 36 is cylindrical in shape and is coupled to the bottom of the dome 24.

The inner rubber insert 27 and outer rubber insert 28 are coupled to the sub carrier 38, which in turn is coupled to the base flange 36, thereby enabling the inserts 27 and 28 to pivotly contact a substrate being acted upon by the polishing head 300. The sub carrier 38 is disk shaped and in conjunction with the inserts 27 and 28 form the center zone and edge zone described above. Pressure is supplied to the center zone and edge zone via the center zone input 310 and edge zone input 305, respectively.

FIG. 5 is a second cross section illustrating the polishing head 300 of FIG. 3. The cross section of FIG. 5 illustrates the coupling of the base flange 36 to the flange drive 23 via two assemblies 500 and 510. The first assembly 500 comprises a collar 16; a cap 17; a screw 2; a rubber cushion 22; a washer 7 and a pin 11. The pin 11 is circumscribed by the collar 16 and topped with the cap 17. In addition, the rubber cushion 22 is located between the pin 11 and the collar 16 so as to cushion the interface between the pin 11 and the collar 16. The washer 7 is located at the interface between the base flange 36 and flange drive 23 and circumscribes the pin 11. The first assembly 500 enables the polishing head 300 to transfer torque when the shaft rotates the flange drive 23.

The second assembly 510 comprises a washer 8; a spring 12; a washer 9; and a screw 33. The screw 33 couples the base flange 36 to the flange drive 23. The spring 12 circumscribes the screw 33 and enables rebound of the base flange 36 due to pivoting. The second assembly 510 also includes the washers 8 and 9 that are located at the top of the screw 33 and at the interface between the diaphragm support ring alpha gimbal 36 and the flange drive 23. The second assembly 510 enables the head 300 to hang from the flange drive 23. It will be appreciated by one of ordinary skill in the art that the polishing head 300 can include additional assemblies that are substantially similar to the first assembly 500 and/or second assembly 510. For example, in an embodiment of the invention, the polishing head 300 includes three assemblies substantially similar to the first assembly 500 and three assemblies substantially similar to the second assembly 510.

FIG. 6 is a third cross section illustrating the polishing head 300 of FIG. 3. Components of the polishing head 300 that are visible in this cross section include an upper housing 37; a seal ring 1; a tube 30; a screw 32; the ceramic balls 25; a cross flat countersunk 29; the flange drive 23; the dome adapter 24; the ball holder drive flange 25; a retaining ring 20; the sub carrier 38; the inner rubber insert 27; an inner diaphragm support 34; the diaphragm support ring alpha gimbal 36; an o-ring 13; the outer rubber insert 28; the adapter 15; a stop ring 21; a lower housing 19; a stopper 18; and a primary diaphragm 35.

The retaining ring 20 is ring shaped and retains a substrate during CMP. The retaining ring 20 also circumscribes the disc shaped sub carrier 38. Downward pressure is applied to the retaining 20 to place it the retaining ring 20 in contact with a polishing pad via the retaining ring input 315 (e.g., tube 30).

The retaining ring 20 is coupled to the diaphragm 35 with a seal ring 1 so as to bind the diaphragm 35. The outer edge of the diaphragm 35 is bounded by the upper housing 37 the lower housing 19, the inner edge of the diaphragm 35 is bounded by the upper.housing 37 and the base flange 36, thereby forming a cylindrical chamber capable of receiving pressurized air so that the retaining ring 20 can exert a downward pressure against the polishing pad.

During CMP, pressure is supplied against the retaining ring 20 in the retaining ring zone, to the center zone and to the edge zone. The pressures in the center zone and edge zone push the inner rubber insert 27 and outer rubber insert 28 downward against the substrate, causing the substrate to interact with the polishing pad. The pressure in the chambers gives the upward force against the dome 24 via relative parts. Accordingly, the dome 24 contacts the drive flange 23 during polishing. Further, the head in enabled to pivot during polishing as a result of the dome and the drive flange 23.

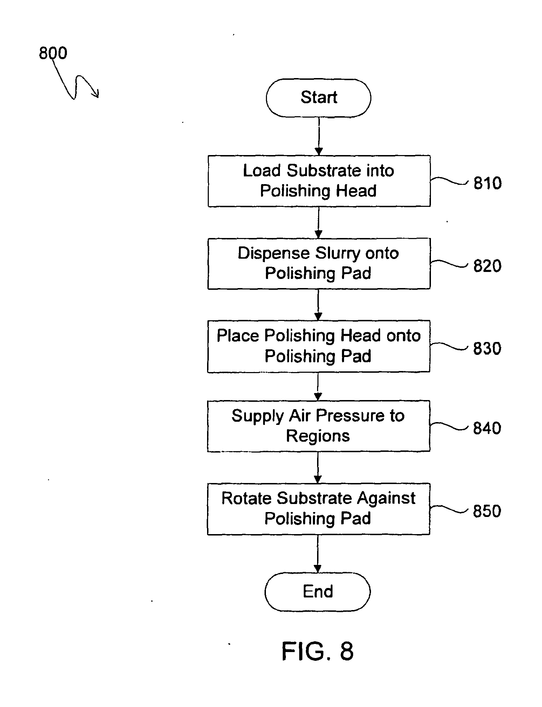

FIG. 8 is a flowchart illustrating a method 800 of chemical mechanical polishing. First, a substrate for polishing is loaded (810) into a polishing head, such as polishing head 200 or 300, for polishing. After the substrate has been load (810), a slurry is dispensed (820) onto the polishing pad. The slurry can include silica (and/or other abrasives) suspended in a mild etchant, such as potassium or ammonium hydroxide. The polishing head is then placed (830) on the polishing pad.

Air pressure is supplied (840) to the various zones of the polishing head. For example, air can be supplied to zones 217 and 295 of the polishing head 200. After supplying (840) air pressure, the substrate is rotated (850) against the polishing pad. The combination of chemical reaction from the slurry and mechanical buffing from the pad removes vertical inconsistencies on the surface of the substrate, thereby forming an extremely flat surface.

It will be appreciated that the supplying (840), dispensing (820), and rotating (850) and placing (830) can be performed in an order different from that described above. In addition, it will be appreciated that the dispensing (820), the supplying (840) and the rotating (850) call all be performed substantially simultaneously.

FIG. 9A - 9D are block diagrams illustrating a polishing system 900 incorporating a height-adjustable head. The system 900 includes the head 200 coupled to a cylindrical shaft 930, which travels through a support arm 940. A mounting assembly 910 is fixed to the shaft 930 and to a sensor assembly 920. The support arm 940 has a stopper assembly 945 located on a top of the support arm 940 adjacent and parallel to the shaft 930. The stopper assembly 945 is located on the support arm 940 in a position that is directly below the sensor assembly 920 so that the sensor assembly 920 has a direct unobstructed view of the stopper assembly 945.

The sensor assembly 920, as shown in more detail in FIG. 9B, includes a sensor 960 surrounded by a bracket 950. The sensor 960 can include an IR range finder or other sensor (e.g., ultrasound) capable of determining a distance between the sensor 960 and the top of the stopper assembly 945. The sensor 960 is recessed a distance Z within the bracket 950 so as to protect the sensor 960 from damage when the sensor assembly is in contact with the stopper assembly 945, as will be discussed in further detail below in conjunction with the FIG. 10. In an embodiment of the invention, Z is equal to about 10 mm.

The stopper assembly 945 includes a stopper coupled to a servomotor (not shown) that is located within the support arm 940. The servomotor moves the stopper in a vertical direction from a low position, as shown in FIG. 9A up to a height of Y-Z+X above the low position. The servomotor can also move the head 200 in a vertical direction. Y is the distance between the sensor 960 and the stopper when the head 200 is positioned to compress the insert 210 against the sub carrier 260 as shown in FIG. 9C. The value of Y decreases slightly after each substrate 120 polishing due to pad wear. For example, Y can decrease by about 0.3 µm to up to about 10.0 µm per substrate 120 polishing. Depending on the sensitivity of the servomotor, Y can be measured after every CMP process or after a certain number of intervals. For example, if the servomotor is capable of raising the stopper to a position with an accuracy of 50 µm, then Y can be calculated after every 10 to 50 CMP processes.

X is the distance between the sub carrier 260 and the insert 210 during polishing as shown in FIG. 9D, i.e., the height of the zone 295. In an embodiment of the invention, X is equal to about 0.5 mm.

It will be appreciated by one of ordinary skill in the art that the system 900 can use different polishing heads, such as heads 100 or 300.

FIG. 10 is a block diagram illustrating the polishing system 900 in an uncompressed state, i.e., in position for CMP. After the sensor 960 measures Y, the head 200 is raised so that the bottom of the sensor assembly 920 is positioned at a height above the stopper assembly 945 equal to Y-Z+X. The servomotor then raises the stopper so that the top of the stopper is located at Y-Z+X above the original lowered stopper position. The head 200 is then lowered, if necessary, to a CMP position until the sensor assembly 920 contacts the stopper. It will be appreciated by adjusting vertical position by servo motor without using stopper. Also vertical distance will be measured by a pulse signal from servo motor instead of using the sensor.

In an embodiment of the invention, the head 200 can be lowered to different height during different steps of the CMP. For example, total polishing time is set to 100 seconds and comprise three different polishing sequences at different heights. The first could be for 30 seconds with polishing condition A, the second could move to polishing condition B for 60 seconds and the last to polishing condition C for 10 seconds. In a Cu circuit process, Cu metal is first removed on the circuit and then a barrier metal below the Cu is removed. Material on both Cu and barrier layer is different and therefore uses different slurry and conditions for removing each material. Therefore, 2 or more different conditions (polishing step) are set in the Cu process. The vertical position of the polishing head is one of parameter that determines polishing performance and needs to change between the Cu and barrier layer polishing steps. As a result, vertical position is not fixed in one position during whole polishing but fixed during each polishing step.

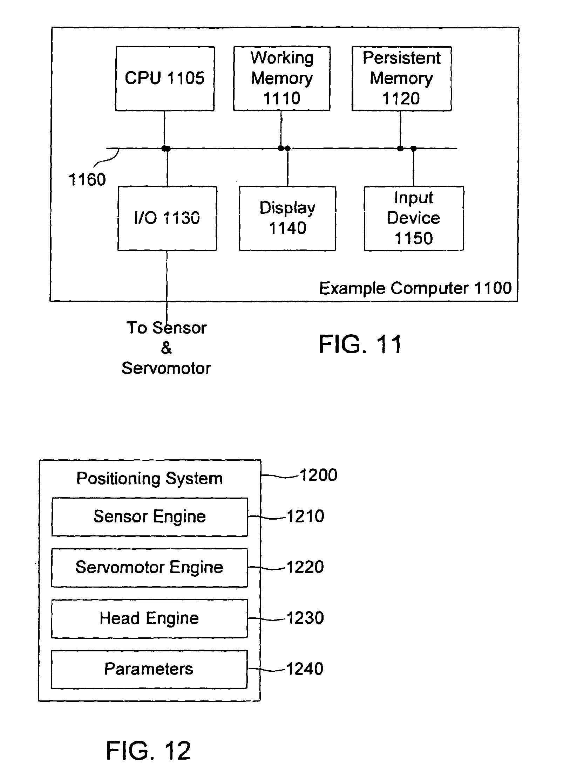

FIG. 11 is a block diagram illustrating an example computer 1100 capable of controlling the polishing system 900. The example computer 1100 can be located within the support arm 940 or at any other location and is communicatively coupled, via wired or wireless techniques, to the servomotor and to the sensor 960. Use of the computer 1100 to control the servomotor and the sensor 960 will be discussed further below in conjunction with FIG. 12. The example computer 1100 includes a central processing unit (CPU) 1105; working memory 1110; persistent memory 1120; input/output (I/O) interface 1130; display 1140 and input device 1150, all communicatively coupled to each other via a bus 1160. The CPU 1105 may include an INTEL PENTIUM microprocessor, a Motorola POWERPC microprocessor, or any other processor capable to execute software stored in the persistent memory 1120. The working memory 1110 may include random access memory (RAM) or any other type of read/write memory devices or combination of memory devices. The persistent memory 1120 may include a hard drive, read only memory (ROM) or any other type of memory device or combination of memory devices that can retain data after the example computer 1100 is shut off. The I/O interface 1130 is communicatively coupled, via wired or wireless techniques, to the sensor 960 and the servomotor. The display 1140, like other components of the computer 1100, is optional and may include a cathode ray tube display or other display device. The input device 1150, which is also optional, may include a keyboard, mouse, or other device for inputting data, or a combination of devices for inputting data.

One skilled in the art will recognize that the example computer 1100 may also include additional devices, such as network connections, additional memory, additional processors, LANs, input/output lines for transferring information across a hardware channel, the Internet or an intranet, etc. One skilled in the art will also recognize that the programs and data may be received by and stored in the system in alternative ways. Further, in an embodiment of the invention, an ASIC is used in placed of the computer 1100 to control the servomotor and the sensor 960.

FIG. 12 is a block diagram illustrating a positioning system 1200, which can be resident on the example computer 1100. The positioning system 1200 communicates with the sensor 960 and the servomotor and control movement of the sensor 960 and the head 200 via control of the servomotor. The positioning system 1200 includes a sensor engine 1210, a servomotor engine 1220, a head engine 1230, and a parameters file 1240. The sensor engine 1210 controls the sensor 960 including turning the sensor 960 on and off to get a distance reading. The servomotor engine 1220 controls the vertical movement of the stopper and the head 200 in response to calculations made by the head engine 1230. The head engine 1230 calculates the position the head 200 should be in for CMP based on readings from the sensor 960 and values stored in the parameters file 1240. The parameters file 1240 stores values X and Z. In an embodiment of the invention X and Z are equal to about 0.5 mm and 10 mm, respectively.

In an embodiment of the invention, the parameters file 1240 can also include a maximum Y value that corresponds with the maximum pad wear. The head engine 1230 can compare the measured Y value with the maximum Y value to determine if Y exceeds the maximum Y value. If the measured Y does exceed the maximum Y, the head engine 1230 can alert an operator of the system 900 that the pad 270 has exceeded the maximum pad wear and the operator can then replace the pad 270 with a new pad before initiating CMP.

In another embodiment of the invention, the parameters file 1240 includes pad wear rate data, which is calculated by measuring the difference in pad height between consecutive polishings. Alternatively, the pad wear data rate can be calculated by measuring the difference in pad height between a first polishing and a later polishing (e.g., 50^{th}) and dividing the difference by the number of polishings between measurements. The parameters file 1240, in this embodiment, can also hold a head height for polishing when using a new polishing pad. Accordingly, depending on the sensitivity of the servomotor, the head engine 1230 can then use the pad wear rate data to recalculate the proposed position of the head 200 for every polishing after a pre-specified number of polishings. For example, the head position could be calculated as the original head height (when using a new polishing pad) less the pad wear rate times the number of polishings.

In another embodiment of the invention, the parameters file 1240 also stores vertical positioning information for different steps during a polishing process. For example, as described above, the head could be positioned at a first height for polishing Cu and then positioned at a second height for polishing a barrier layer.

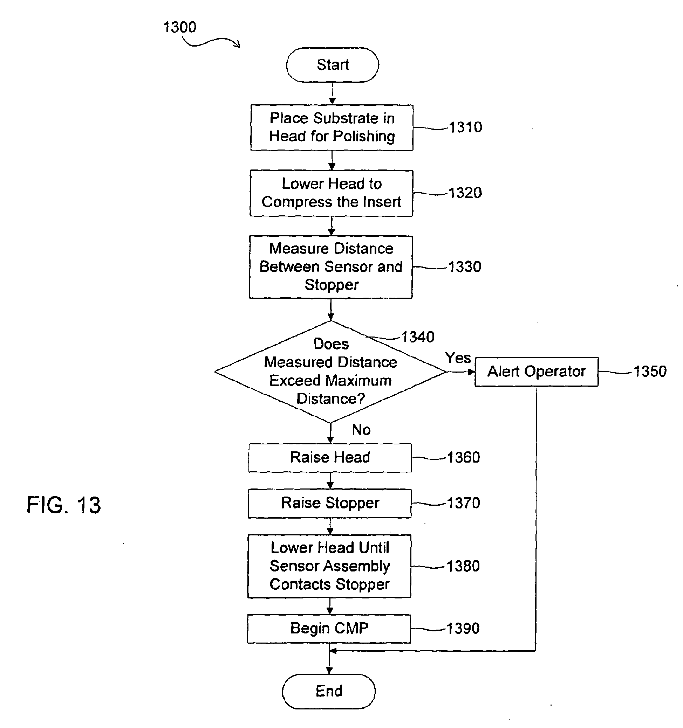

FIG. 13 is a flowchart illustrating a method 1300 of positioning a CMP head 200. First, a substrate 120 is placed (1310) in the head 200. Next, the head 200 is lowered (1320) so as to compress the sub carrier 260 against the insert 210. The distance is then measured (1330) between the sensor 960 and the top of the stopper assembly 945 to yield the value Y. If is then determined (1340) if the value Y exceeds a maximum Y value. If it does, then the operator is warned (1350) via aural, visual, tactile and/or other techniques that pad wear exceeds recommended amounts and the method 1300 ends. Otherwise, the head 200 is then raised (1360) and the stopper is raised (1370) to a height above its lowered position equal to Y-Z+X. The head 200 is then lowered (1380) until the sensor assembly 920 contacts the stopper assembly 945. CMP can then begin (1390). In an embodiment of the invention, CMP (1390) can comprise different steps that adjust the vertical position of the head 200 to polish different layers of the substrate 120. The method 1300 then ends.

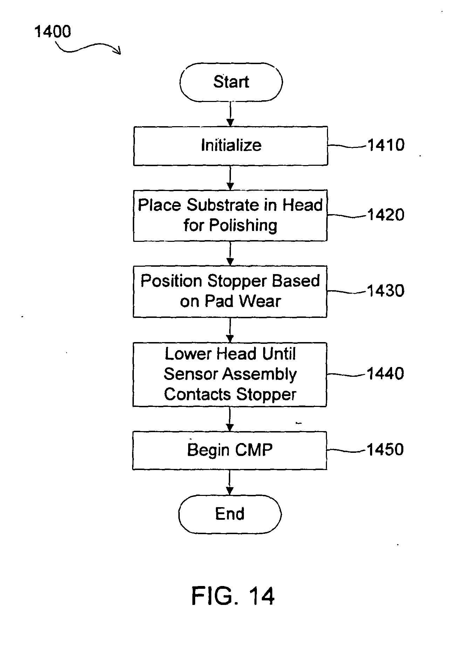

FIG. 14 is a flowchart illustrating a second method 1400 of positioning a CMP head 200. First, the system is initialized (1410), which can include calculating a pad wear rate and determining the compressibility of the head (i.e., the distance X). The pad wear rate can be calculated by measuring the difference in pad height between consecutive polishings. Alternatively, the pad wear data rate can be calculated by measuring the difference in pad height between a first polishing and a later polishing (e.g., 50^{th}) and dividing the difference by the number of polishings between measurements. The compressibility of the pad can be measured by measuring the height of the head before and after compressing it against a polishing pad.

After initialization (1410), a substrate is placed (1420) in the head for polishing. The stopper is then positioned (1430), e.g., raised, so that when the head is lowered (1440) it is positioned to compensate for pad wear. The positioning can be calculated by subtracting the pad wear rate times the number of polishings from the original head height. After positioning (1430) the stopper, the head is lowered (1440) until the sensor assembly contacts the stopper. CMP then begins (1450) and the method 1400 ends.

The foregoing description of the illustrated embodiments of the present invention is by way of example only, and other variations and modifications of the above-described embodiments and methods are possible in light of the foregoing teaching. For example, the embodiments described herein are not intended to be exhaustive or limiting. The present invention is limited only by the following claims.

## Claims

1. An chemical mechanical polishing apparatus for polishing a substrate placed on a polishing pad with an adjustable head comprising:
a sub-carrier (260);
a positioning system (1200); and
a rubber insert (210) coupled to the sub-carrier (260) to form a chamber (280, 290, 295);
**characterized in that**
the positioning system (1200) is configured to position the sub-carrier (260) to an initial position at a predetermined distance from a polishing pad (270) in preparation for each polishing operation, wherein when the sub-carrier (260) is at initial position the rubber insert (210) is compressed against the sub-carrier (260),
the positioning system (1200) is configured to determine wear of the polishing pad (270),
the positioning system (1200) is configured to move the sub-carrier (260) from the initial position to a second position by a distance (X), and air is supplied to the chamber (280, 290, 295) to provide a pressure within the chamber (280, 290, 295) to press the substrate against the polishing pad (270).

2. The polishing apparatus of claim 1, wherein the polishing apparatus further comprises a retaining ring (220) capable of retaining the substrate during polishing.

3. The polishing apparatus of claim 1, wherein the polishing apparatus further comprises a housing (215, 37, 19) coupled to a diaphragm, wherein the retaining ring (220) is coupled to the diaphragm so as to form a chamber capable of receiving air that provides a downward force on the retaining ring (220).

4. The polishing apparatus of claim 3, further comprising means for varying the pressure of the air that provides the downward force on the retaining ring (220).

5. The polishing apparatus of claim 1, wherein the polishing apparatus further comprises a pivot mechanism (250) that is coupled to the sub-carrier (260) capable of pivoting the sub-carrier (260) so as to maintain the sub-carrier level parallel to the polishing pad (270).

6. The polishing apparatus of claim 1, wherein the rubber insert (210) and sub-carrier (260) form a plurality of chambers (280, 290, 295) capable of receiving air during polishing.

7. The polishing apparatus of claim 6, further comprising means for varying the pressure of the air in the plurality of chambers (280, 290, 295).

8. The polishing apparatus of claim 1, further comprising means for varying the pressure of the air

9. The polishing apparatus of claim 1, wherein the distance between the sub-carrier (260) and the rubber insert (210) during polishing is controlled within about 0.5 mm or less resolution.

10. The polishing apparatus of claim 1, wherein the polishing apparatus further comprises a reference point (230) on a bottom surface of the sub-carrier (260), the reference point (230) being capable of contacting the substrate on the polishing pad (270) and limiting the downward movement of the sub-carrier (260) so as to determine the position of the polishing pad top surface.

11. The polishing apparatus of claim 10, wherein the polishing apparatus further comprises a soft pad on the bottom surface of the reference point (230).

12. The polishing apparatus of claim 11, wherein the soft pad is less compressive than the rubber insert (210).

13. The polishing apparatus of claim 1, wherein:
the positioning system (1200) includes a bracket (950) coupled to the sub-carrier (260) such that the bracket (950) moves with the sub-carrier (260); the stopper assembly (945) includes a stopper and a motor for moving the stopper along a movement path of the bracket (950);
the sensor assembly (920) includes a sensor (960) for measuring the distance between the bracket (950) and the stopper when the sub-carrier (260) is at the first position; and
the motor of the stopper assembly (945) is configured to move the stopper by a distance that is equal to the give distance (X) and the distance between the bracket (950) and the stopper when the sub-carrier (260) is at the first position.

14. A method of chemical mechanical polishing of a substrate against a polishing pad, the method comprising:
positioning a sub-carrier (260) at an initial position in preparation for a substrate polishing operation on a polishing pad (270), the sub-carrier (260) being coupled to a rubber insert (210) for carrying the substrate and coupled to a positioning system (1200),
**characterized in that**
the positioning system (1200) determines wear of the polishing pad (270),
the positioning system (1200) moves the sub-carrier (260) from the initial position to a second position by a distance (X), and
air is supplied to a chamber (280, 290, 295) to provide a pressure within the chamber (280, 290, 295) to press the substrate against the polishing pad (270).

15. The method of claim 14, wherein positioning a sub-carrier (260) at an initial position in preparation for a substrate polishing operation on a polishing pad (270) includes moving the sub-carrier (260) to the initial position at which the rubber insert (210) is compressed against the sub-carrier (260).

16. The method of claim 15, wherein pad wear is determined based at least on a first factor multiplied by a second factor, the first factor being representative of wear rate of the polishing pad (270) and the second factor being representative of cumulative usage of the polishing pad (270).

17. The method of claim 16, wherein the first factor is based at least on the quotient of a dividend and a divisor, the dividend being representative of a difference in pad height between a first previous polishing operation using the polishing pad (270) and a second previous polishing operation using the polishing pad (270), the divisor being representative of the total number of polishing operations using the polishing pad (270) from the first previous polishing operation to the second previous polishing operation.

18. The method of claim 17, wherein the second factor is based at least on the total number of polishing operations on the polishing pad (270) since the first previous polishing operation.

19. The method of claim 18, wherein the method further comprises the step of:
moving the stopper to a stopper location relative to the polishing head, the stopper location being based on at least a wear parameter of the polishing pad (270) and a compressibility parameter of the rubber insert (210); wherein the step of positioning the sub-carrier in preparation for the polishing operation includes moving the sub-carrier (260) until a member coupled to the sub-carrier (260) contacts the stopper.

20. The method of claim 19, wherein the wear parameter is associated with a change in polishing pad height since a previous polishing operation using the polishing pad.

21. The method of claim 19, wherein the compressibility parameter corresponds to a difference in location of the sub-carrier (270) from when the rubber insert (210) is compressed against the sub-carrier (270) and to when the rubber insert (210) becomes uncompressed against the sub-carrier (270).

## Patentansprüche

1. Eine chemisch-mechanische Poliervorrichtung zum Polieren eines Substrats, das mit einem einstellbaren Kopf auf ein Polierissen platziert ist, wobei die Vorrichtung Folgendes aufweist:
einen Unterträger (260);
ein Positioniersystem (1200); und
einen Gummieinsatz (210), der mit dem Unterträger (260) gekoppelt ist, um eine Kammer (280, 290, 295) zu bilden;
**dadurch gekennzeichnet, dass**
das Positioniersystem (1200) konfiguriert ist zum Positionieren des Unterträgers (260) zu einer Anfangsposition mit einem vorbestimmten Abstand bezüglich eines Polierkissens (270), und zwar in Vorbereitung für jeden Poliervorgang, wobei dann, wenn der Unterträger (260) in der Anfangsposition ist, der Gummieinsatz (210) gegen den Unterträger (260) zusammengedrückt ist,
das Positioniersystem (1200) konfiguriert ist zum Bestimmen einer Abnutzung des Polierkissens (270),
das Positioniersystem (1200) konfiguriert ist zum Bewegen des Unterträgers (260) aus der Anfangsposition zu einer zweiten Position über einen Abstand (X), und das Luft zu der Kammer (280, 290, 295) geliefert wird zum Vorsehen eines Drucks innerhalb der Kammer (280, 290, 295), um das Substrat gegen das Polierkissen (270) zu drücken.

2. Poliervorrichtung nach Anspruch 1, wobei die Poliervorrichtung ferner einen Haltering (220) aufweist, der in der Lage ist, das Substrat während des Polierens zu halten.

3. Poliervorrichtung nach Anspruch 1, wobei die Poliervorrichtung ferner ein Gehäuse (215, 37, 19) aufweist, das mit einer Membran gekoppelt ist, wobei der Haltering (220) mit der Membran gekoppelt ist, um eine Kammer zu bilden, die in der Lage ist, Luft aufzunehmen, welche eine nach unten gerichtete Kraft auf den Haltering (220) vorsieht.

4. Poliervorrichtung nach Anspruch 3, die ferner Mittel aufweist zum Variieren des Drucks der Luft, welche die nach unten gerichtete Kraft auf den Haltering (220) vorsieht.

5. Poliervorrichtung nach Anspruch 1, wobei die Poliervorrichtung ferner einen Schwenkmechanismus (250) aufweist, der mit dem Unterträger (260) gekoppelt, und der in der Lage ist, den Unterträger (260) zu schwenken, um das Unterträgerniveau parallel zu dem Polierkissen (270) zu halten.

6. Poliervorrichtung nach Anspruch 1, wobei der Gummieinsatz (210) und der Unterträger (260) eine Vielzahl von Kammern (280, 290, 295) bilden, die in der Lage sind, Luft während des Polierens zu empfangen.

7. Poliervorrichtung nach Anspruch 6, die ferner Mittel aufweist zum Variieren des Drucks der Luft in der Vielzahl von Kammern (280, 290, 295).

8. Poliervorrichtung nach Anspruch 1, die ferner Mittel aufweist zum Variieren des Drucks der Luft.

9. Poliervorrichtung nach Anspruch 1, wobei der Abstand zwischen dem Unterträger (260) und dem Gummieinsatz (210) während des Polierens mit einer Auflösung von 0,5 mm oder kleiner kontrolliert wird.

10. Poliervorrichtung nach Anspruch 1, wobei die Poliervorrichtung ferner einen Bezugspunkt (230) an einer Unterseite des Unterträgers (260) aufweist, wobei der Bezugspunkt (230) in der Lage ist, das Substrat auf dem Polierkissen (270) zu kontaktieren und die nach unten gerichtete Bewegung des Unterträgers (260) zu begrenzen, um die Position der Polierkissenoberseite bzw. -oberfläche zu bestimmen.

11. Poliervorrichtung nach Anspruch 10, wobei die Poliervorrichtung ferner ein weiches Kissen an der Unterseite des Bezugspunkts (230) aufweist.

12. Poliervorrichtung nach Anspruch 11, wobei das weiche Kissen weniger zusammendrückbar ist als der Gummieinsatz (210).

13. Poliervorrichtung nach Anspruch 1, wobei das Positioniersystem (1200) einen Bügel (950) aufweist, der mit dem Unterträger (260) gekoppelt ist, so dass der Bügel (950) sich mit dem Unterträger (260) bewegt;
wobei eine Anschlaganordnung (945) einen Anschlag und einen Motor zum Bewegen des Anschlags entlang eines Bewegungspfades des Bügels (950) aufweist;
wobei eine Sensoranordnung (920) einen Sensor (960) aufweist zum Messen des Abstands zwischen dem Bügel (950) und dem Anschlag, wenn der Unterträger sich in der ersten Position befindet; und
wobei der Motor der Anschlaganordnung (945) konfiguriert ist zum Bewegen des Anschlags über einen Abstand, der gleich dem vorgegebenen Abstand (X) und dem Abstand zwischen dem Bügel (950) und dem Anschlag ist, wenn sich der Unterträger (260) in der ersten Position befindet.

14. Ein Verfahren zum chemisch-mechanischen Polieren eines Substrats gegen ein Polierkissen, wobei das Verfahren die folgendes Schritte aufweist:
Positionieren eines Unterträgers (260) in einer Anfangsposition in Vorbereitung für einen Substratpoliervorgang auf einem Polierkissen (270), wobei der Unterträger (260) mit einem Gummieinsatz (210) gekoppelt ist zum Tragen des Substrats und auch mit einem Positioniersystem (1200) gekoppelt ist, **dadurch gekennzeichnet, dass** das Positioniersystem (1200) eine Abnutzung des Polierkissens (270) bestimmt, das Positioniersystem (1200) den Unterträger (260) aus der Anfangsposition zu einer zweiten Position über einen Abstand (X) bewegt, und Luft zu einer Kammer (280, 290, 295) geliefert wird zum Vorsehen eines Drucks innerhalb der Kammer (280, 290, 295), um das Substrat gegen das Polierkissen (270) zu drücken.

15. Verfahren nach Anspruch 14, wobei das Positionieren eines Unterträgers (260) an einer Anfangsposition in Vorbereitung für einen Substratpoliervorgang auf einem Polierkissen (270) das Bewegen des Unterträgers (260) zu der Anfangsposition umfasst, in der der Gummieinsatz (210) gegen den Unterträger (260) zusammengedrückt ist.

16. Verfahren nach Anspruch 15, wobei eine Kissenabnutzung bestimmt wird, basierend auf wenigstens einem ersten Faktor, der mit einem zweiten Faktor multipliziert wird, wobei der erste Faktor eine Abnutzungsrate des Polierkissens (270) repräsentiert, und der zweite Faktor eine kumulative Nutzung des Polierkissens (270) repräsentiert.

17. Verfahren nach Anspruch 16, wobei der erste Faktor wenigstens teilweise auf dem Quotienten eines Dividenden und eines Divisors basiert, wobei der Dividend eine Differenz in der Pfadhöhe zwischen einem ersten vorhergehenden Poliervorgang unter Verwendung des Polierkissens (270) und eines zweiten vorhergehenden Poliervorgangs unter Verwendung des Polierkissens (270) repräsentiert und der Divisor die Gesamtanzahl von Poliervorgängen unter Verwendung des Polierkissens (270) von dem ersten vorhergehenden Poliervorgang zu dem zweiten vorhergehenden Poliervorgang repräsentiert.

18. Verfahren nach Anspruch 17, wobei der zweite Faktor wenigstens teilweise auf der Gesamtanzahl von Poliervorgängen auf dem Polierkissen (270) seit dem ersten vorhergehenden Poliervorgang basiert.

19. Verfahren nach Anspruch 18, wobei das Verfahren ferner den Schritt aufweist des Bewegens des Anschlags zu einem Anschlagort bezüglich des Polierkopfs, wobei der Anschlagort basiert auf wenigstens einem Abnutzungparameter des Polierkissens (270) und einem Kompressibilitätsparameter des Gummieinsatzes (210);
wobei der Schritt des Positionierens des Unterträgers in Vorbereitung für den Poliervorgang das Bewegen des Unterträgers (260) umfasst bis ein mit dem Unterträger (260) gekoppeltes Glied den Anschlag kontaktiert.

20. Verfahren nach Anspruch 19, wobei der Abnutzungsparameter assoziiert ist mit einer Veränderung der Polierkissenhöhe seit einem vorhergehenden Poliervorgang unter Verwendung des Polierkissens.

21. Verfahren nach Anspruch 19, wobei der Kompressibilitätsparameter einer Differenz der Anordnung des Unterträgers (270) entspricht zwischen einer Situation, in der der Gummieinsatz (210) gegen den Unterträger (270) zusammengedrückt ist und einer Situation, wenn der Gummieinsatz (210) nicht gegen den Unterträger (270) zusammengedrückt ist.

## Revendications

1. Dispositif de polissage mécano-chimique pour polir un substrat placé sur un tampon de polissage avec une tête ajustable, comprenant :
un support (260) ;
un système de positionnement (1200) ; et
un insert en caoutchouc (210) couplé au support (260) pour former une chambre (280, 290, 295) ;
**caractérisé en ce que**
le système de positionnement (1200) est agencé pour positionner le support (260) dans une position initiale à une distance prédéterminée par rapport à un tampon de polissage (270) en préparation de chaque opération de polissage, dans lequel lorsque le support (260) est dans la position initiale l'insert de caoutchouc (210) est comprimé contre le support (260),
le système de positionnement (1200) est agencé pour déterminer l'usure du tampon de polissage (270),
le système de positionnement (1200) est agencé pour déplacer le support (260) de la position initiale vers une deuxième position d'une distance (X), et de l'air est fourni à la chambre (280, 290, 295) pour assurer une pression dans la chambre (280, 290, 295) pour presser le substrat contre le tampon de polissage (270).

2. Dispositif de polissage selon la revendication 1, dans lequel le dispositif de polissage comprend en outre une bague de maintien (220) capable de maintenir le substrat pendant le polissage.

3. Dispositif de polissage selon la revendication 1, dans lequel le dispositif de polissage comprend en outre un carter (215, 37, 19) couplé à un diaphragme, dans lequel la bague de maintien (220) est couplée au diaphragme de manière à former une chambre capable de recevoir de l'air qui assure une force vers le bas sur la bague de maintien (220).

4. Dispositif de polissage selon la revendication 3, comprenant en outre des moyens pour faire varier la pression de l'air qui assure la force vers le bas sur la bague de maintien (220).

5. Dispositif de polissage selon la revendication 1, dans lequel le dispositif de polissage comprend en outre un mécanisme de pivot (250) qui est couplé au support (260), capable de faire pivoter le support (260) de façon à maintenir le niveau du support parallèle au tampon de polissage (270).

6. Dispositif de polissage selon la revendication 1, dans lequel l'insert de caoutchouc (210) et le support (260) forment une pluralité de chambres (280, 290, 295) capables de recevoir de l'air pendant le polissage.

7. Dispositif de polissage selon la revendication 6, comprenant en outre des moyens pour faire varier la pression de l'air dans la pluralité de chambres (280, 290, 295).

8. Dispositif de polissage selon la revendication 1, comprenant en outre des moyens pour faire varier la pression de l'air.

9. Dispositif de polissage selon la revendication 1, dans lequel la distance entre le support (260) et l'insert de caoutchouc (210) pendant le polissage est contrôlée pour avoir une résolution d'environ 0.5 mm ou moins.

10. Dispositif de polissage selon la revendication 1, dans lequel le dispositif de polissage comprend en outre un point de référence (230) sur une surface inférieure du support (260), le point de référence (230) étant capable de contacter le substrat sur le tampon de polissage (270) et de limiter le mouvement vers le bas du support (260) de manière à déterminer la position de la surface supérieure du tampon de polissage.

11. Dispositif de polissage selon la revendication 10, dans lequel le dispositif de polissage comprend en outre un tampon doux sur la surface inférieure du point de référence (230).

12. Dispositif de polissage selon la revendication 11, dans lequel le tampon doux est moins compressible que l'insert de caoutchouc (210).

13. Dispositif de polissage selon la revendication 1, dans lequel :
le système de positionnement (1200) comprend un tasseau (950) couplé au support (260) de telle sorte que le tasseau (950) se déplace avec le support (260) ;
une structure de butée (945) comprend une butée et un moteur pour déplacer la butée le long d'un trajet de mouvement du tasseau (950) ;
une structure de capteur (920) comprend un capteur (960) pour mesurer la distance entre le tasseau (950) et la butée lorsque le support (260) est dans la première position ; et
le moteur de la structure de butée (945) est agencé pour déplacer la butée d'une distance qui est égale à la distance donnée (X) plus la distance entre le tasseau (950) et la butée lorsque le support (260) est dans la première position.

14. Procédé de polissage mécano-chimique d'un substrat contre un tampon de polissage, le procédé comprenant :
positionner un support (260) à une position initiale en préparation d'une opération de polissage d'un substrat sur un tampon de polissage (270), le support (260) étant couplé à un insert en caoutchouc (210) pour transporter le substrat et couplé à un système de positionnement (1200),
**caractérisé en ce que** le système de positionnement (1200) détermine l'usure du tampon de polissage (270),
le système de positionnement (1200) déplace le support (260) de la position initiale vers une deuxième position d'une distance (X), et
de l'air est fourni à une chambre (280, 290, 295) pour assurer une pression dans la chambre (280, 290, 295) pour presser le substrat contre le tampon de polissage (270).

15. Procédé selon la revendication 14, dans lequel le positionnement d'un support (260) à une position initiale en préparation d'une opération de polissage de substrat sur un tampon de polissage (270) comprend le déplacement du support (260) vers la position initiale à laquelle l'insert de caoutchouc (210) est comprimé contre le support (260).

16. Procédé selon la revendication 15, dans lequel l'usure du tampon est déterminée sur la base d'au moins un premier facteur multiplié par un deuxième facteur, le premier facteur étant représentatif du taux d'usure du tampon de polissage (270) et le deuxième facteur étant représentatif d'une usure cumulative du tampon de polissage (270).

17. Procédé selon la revendication 16, dans lequel le premier facteur est basé au moins sur le quotient d'un dividende et d'un diviseur, le dividende étant représentatif d'une différence de hauteur du tampon entre une première opération de polissage précédente utilisant le tampon de polissage (270) et une deuxième opération de polissage précédente utilisant le tampon de polissage (270), le diviseur étant représentatif du nombre total d'opérations de polissage utilisant le tampon de polissage (270) à partir de la première opération de polissage précédente jusqu'à la deuxième opération de polissage précédente.

18. Procédé selon la revendication 17, dans lequel le deuxième facteur est basé au moins sur le nombre total d'opérations de polissage sur le tampon de polissage (270) depuis la première opération de polissage précédente.

19. Procédé selon la revendication 18, dans lequel le procédé comprend en outre l'étape suivante :
déplacer la butée vers un emplacement de butée par rapport à la tête de polissage, l'emplacement de butée étant basé sur au moins un paramètre d'usure du tampon de polissage (270) et un paramètre de compressibilité de l'insert en caoutchouc (210) ;
dans lequel l'étape de positionnement du support en préparation de l'opération de polissage comprend le déplacement du support (260) jusqu'à ce qu'un élément couplé au support (260) entre en contact avec la butée.

20. Procédé selon la revendication 19, dans lequel le paramètre d'usure est associé à un changement de la hauteur du tampon de polissage depuis une opération de polissage précédente utilisant le tampon de polissage.

21. Procédé selon la revendication 19, dans lequel le paramètre de compressibilité correspond à une différence de position du support (270) entre le moment où l'insert de caoutchouc (210) est comprimé contre le support (270) et le moment où l'insert en caoutchouc (210) devient non comprimé contre le support (270).
